# EUROPEAN PATENT SPECIFICATION

(11) **EP 4 128 454 B1**
(45) Date of publication and mention of the grant of the patent: **27.05.2026**
(21) Application number: 20722524.4
(22) Date of filing: 24.04.2020
(51) Int. Cl.: H01S 5/042, H01S 5/062, H01S 5/068, H01S 5/42, G01S 7/484

(54) **LASER DRIVER**
LASERTREIBER
PILOTE DE LASER

(43) Date of publication of application: 08.02.2023
(73) Proprietor: Huawei Technologies Co., Ltd., Shenzhen, Guangdong 518129, (CN)
(72) Inventor: LEE, Denise, 80992 Munich (DE)
(74) Representative: Isarpatent
(86) International application number: PCT/EP2020/061424
(87) International publication number: WO 2021/213665

(56) References cited:
- EP-A1- 2 622 942
- EP-A1- 3 297 105
- EP-B1- 2 622 942
- WO-A1-2016/209656
- US-A1- 2006 291 512
- US-A1- 2010 289 424
- US-A1- 2011 085 576
- US-A1- 2018 248 337
- US-A1- 2019 393 674
- US-B1- 9 054 485

## Description

### TECHNICAL FIELD

This invention relates to a laser driver, for example for driving a laser diode (LD) or an array of laser diodes. The driver may perform time division multiplexed (TDM) driving. The driver may perform pulsed driving. The driver may provide temperature compensated peak current control.

### BACKGROUND

It is advantageous to perform such ranging over a two dimensional array, so that a picture of the environment can be built up. To achieve this at a high scanning rate it is advantageous to drive the laser with high power. This can place significant performance demands on the laser driver.

The laser diode may be arranged in an array. Such an array provides multiple independent transmission channels. These are typically driven via an array of isolated anodes, with one common cathode summing node as the return path of the lasing current.

It can be desirable to perform spatial laser transmission beam steering to provide directionality of a transmitted signal towards a target. Preferably, such steering is done in a non-mechanical way. It would be desirable for integrated optics to focus a transmitted signal towards a target.

It would be desirable to be able to set the peak lasing current, in the context of controlling the peak output optical power from the electro-optical conversion of the LD, for optimal operation of the TOF system.

It would be desirable to control the driving of an LD to compensate for any temperature-dependent characteristic in its performance.

US 2006/291512 A1 relates to an apparatus and method for driving laser diodes with electrical power in pulsed operation.

WO 2016/209656 A1 relates to an integrated gate device discharging.

US 2019/393674 A1 relates to a laser diode current driving apparatus.

EP 3 297 105 A1 relates to a driver circuit for a laser diode.

US 9 054 485 B1 relates to an asymmetric edge compensation of both anode and cathode terminals of a vertical-cavity surface-emitting laser (VCSEL) diode.

US 2018/248337 A1 relates to a light source driver circuit that uses a low supply voltage and is capable of operating at high bandwidth.

### SUMMARY

The object of the present application is to provide a laser drive, a laser unit and an optical distance measuring unit. This object is solved by the attached independent claims and further embodiments and improvements of the invention are listed in the attached dependent claims. Hereinafter, up to the "brief description of the drawings", expressions like "...aspect according to the invention", "according to the invention", or "the present invention", relate to technical teaching of the broadest embodiment as claimed with the independent claims. Expressions like "implementation", "design", "optionally", "preferably", "scenario", "aspect" or similar relate to further embodiments as claimed, and expressions like "example", "...aspect according to an example", "the disclosure describes", or "the disclosure" describe technical teaching which relates to the understanding of the invention or its embodiments, which, however, is not claimed as such.

According to one aspect according to the invention there is provided a laser drive circuit comprising: a high supply node for supplying a relatively high voltage; a low supply node for supplying a relatively low voltage; first and second laser drive outputs for connection across a laser to provide a drive current to the laser; a high-side switch coupled between the high supply node and the first laser drive output; and a low-side switch coupled between the low supply node and the second laser drive output; wherein the high-side switch is controlled to regulate the drive current supplied to the laser and the low-side switch is controlled to alternate its state between on and off states so as to pulse the operation of the laser.

The high-side switch may be an NMOS switch. This can provide a sizing benefit.

The laser may be coupled between the high side switch and the low side switch. This can allow the laser to be switched in dependence on both switches. One of the switches (e.g. the high side switch) may be used for enabling the laser in distinction to other lasers in a common array comprising the laser. The other of the switches may be used for modulating the laser and other lasers.

The circuit comprises a gate driver for controlling the high-side switch, and a charge pump for regulating the supply of current to the gate driver under closed loop control. This allows the drive to the laser to be controlled

The drive circuit may be capable of selectively driving each of multiple drive outputs to a laser array. This can allow the driver to serve multiple lasers.

The drive circuit comprises a current driver for supplying current to the high supply node, the current driver being configured to temperature compensate the current supplied to the high supply node. This allows temperature-dependent behaviour of the laser to be compensated for.

The current driver comprises a replica circuit for simulating the temperature response of a circuit including a laser. The output of the current driver may be dependent on the response of the replica circuit. This allow temperature-dependent behaviour of the laser to be compensated for.

The replica circuit may have a current/voltage response that is substantially linear over an operating region which is temperature invariant. This can simulate the behaviour of a laser diode.

The drive circuit may comprise a switching circuit for receiving first and second pulse trains having mutually offset phases, the switching circuit being configured to control the low-side switch to turn on in response to an edge of a first predetermined sense in the first pulse train and to turn off in response to an edge of a second predetermined sense in the second pulse train. This can provide a convenient way to allow fast switching of the low-side switch.

The laser drive circuit may be for driving multiple lasers. The circuit may comprise, for each such laser: a high supply node for supplying a relatively high voltage; a low supply node for supplying a relatively low supply voltage; first and second laser drive outputs for connection across a respective laser to provide a drive current to the laser; a high-side switch coupled between the respective high supply node and the respective first laser drive output; and a low-side switch coupled between the respective low supply node and the respective second laser drive output; wherein the respective high-side switch is controlled to regulate the drive current supplied to the laser and the low-side switch is controlled to alternate its state between on and off states so as to pulse the operation of the laser. Alternatively, there may be a low-side switch that is common to multiple lasers and is controlled to alternate its state between on and off states so as to pulse the operation of the laser. This may provide an efficient way of providing laser selection and pulsing.

The drive circuit may comprise a channel selection circuit for receiving a current supply and selectively directing that current supply to a respective one of the high-side switches. This may allow each of a number of lasers to be selectively enabled. The current supply may be directed by gating it on either the high or the low side of the high-side switch.

The channel selection circuit may comprise a plurality of switches operable to control drive to a respective laser, the switches being configured such that in the event of a failure of any such switch the current path to the respective laser will be interrupted. This can provide brown-out protection.

According to another aspect according to the invention there is provided a laser unit comprising: a laser drive circuit as set out above; and a laser coupled between the or each pair of first and second laser drive outputs.

According to another aspect according to the invention there is provided an optical distance measuring unit comprising a laser unit as set out above, the laser unit being arranged to intermittently irradiate a zone external to the laser unit by switching of respective high side switches, whereby the time of flight of signals from the or each laser to a subject can be measured.

### BRIEF DESCRIPTION OF DRAWINGS

The present system will now be described by way of example with reference to the accompanying drawings. In the drawings:
Figure 1 illustrates significant components of a laser driver
Figure 2 shows a circuit for mirroring and applying gain to a replica lasing current
Figure 3 shows the timing of signals in a laser driver circuit
Figure 4 shows an overall schematic circuit diagram of a laser driver
Figure 5 shows an implementation of a laser driver.
Figure 6 illustrates a temperature compensation replica circuit.

In the following description, features which in the above summary of the invention have been marked as "not claimed" are also hereinafter, when they are described and explained with reference to the drawings, to be understood as "not claimed" or "not part of the invention".

### DESCRIPTION OF EMBODIMENTS

The system to be described below provides a driver suitable for pulsed driving of a laser diode, especially a semiconductor laser diode. The driver may, for example, be used for driving a laser diode array for ranging applications; but other applications are possible: for example driving lasers for illumination.

The system to be described below integrates a pulse modulating switch and a plurality of beam steering channel selection switches. Such a system may provide driving at relatively high instantaneous current (e.g. greater than 30 Amps) and simultaneously relatively high instantaneous voltage (e.g. greater than 15 Volts). It may be capable of switching so as to generate laser pulses of duration less than 1 ns.

In 3D depth sensing using laser ranging, it is generally necessary to limit the transmitter optical power for safety reasons. Acceptable emission limits for inhibiting damage to the eyes of onlookers are defined in, for example, EN60825-1:2014. Such limits set a bound on time duration of exposure to laser energy. To achieve good receiver signal to noise ratio (SNR), i.e. the ratio of target reflected photon flux to ambient photon flux, in a ranging system whilst also limiting laser emission power to an eye-safe level, a tradeoff can be made between the acquisition frame rate over a receiver's field of view (FOV) and improving SNR for ranging distance. The target irradiance (in Watts per unit area) of the same limited output peak optical power output can be increased in both 2D scanning mode (raster scan) and 1D scanning mode (line scan).

An example of a vertical cavity surface emitting laser (VCSEL) for performing 1D line scanning is given in Rainer Michalzik (Ed.), Fundamentals, Technology and Applications of Vertical-Cavity Surface-Emitting Lasers. Further details of an example of such a laser are disclosed in EP 3 588 702. Such devices can have advantages of compactness, which is useful in a system that is intended to be portable - e.g. borne by a vehicle.

One approach to increasing the output optical power of a semiconductor laser is to electrically connect multiple laser diodes in series and combine their optical power outputs as if they were a single transmission source. In such an implementation, compared to driving a single laser diode the operating biasing voltage increases but the lasing current stays the same. A conventional figure of merit of a laser diode is its slope efficiency (given in Watts/Amp). The slope efficiency of the device with multiple LDs in series increases as a multiple of the number of LDs connected in series. To drive such a device for direct TOF system calls for a narrow pulsed current. This requires a fast step change in drive current. Such a drive is needed notwithstanding any parasitic effects that impede such performance. Examples of such parasitic effects are resistance, inductance, capacitance and dielectric losses due to routing interconnects or transmission lines. It is desirable to design a driver for such a system to accommodate the relatively high operating voltage of these diode structures.

The behaviour of a VCSEL is discussed in "A comprehensive Verilog-A VCSEL model for >20Gb/s optical interconnect transceiver circuit design" (Wang et al.). Of interest is the variation in optical power, the variation of threshold current and the variation in the voltage versus current basing characteristic, with respect to temperature.

The system to be described below provides an implementation for a time division multiplexed laser diode driver for pulsed current operation with temperature compensated peak current control. Embodiments are suitable for use in a TOF ranging system and in other applications.

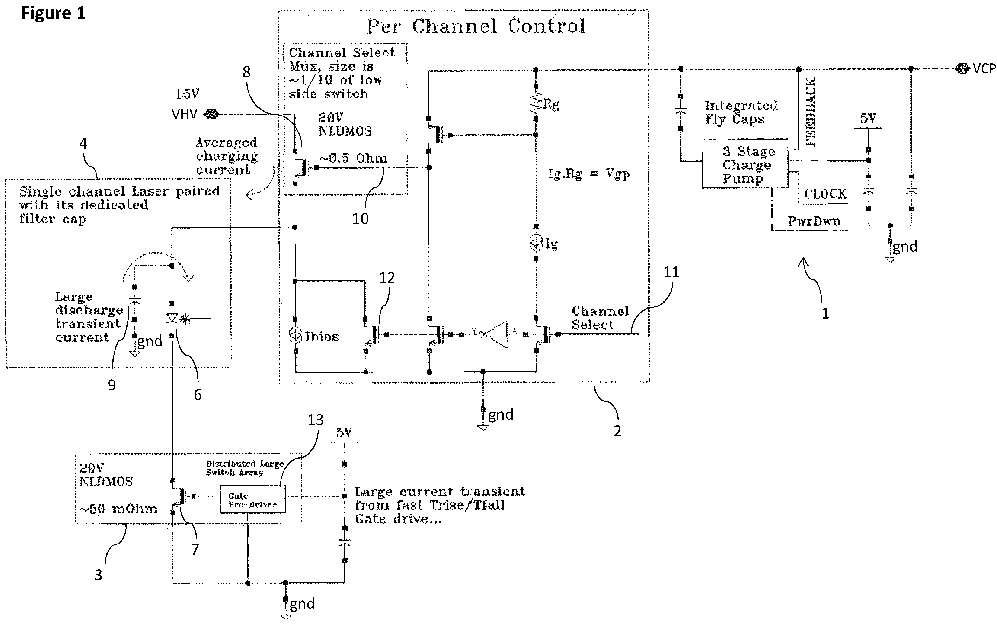

Figure 1 illustrates the principle of operation of the present laser driver for time division multiplexing and the gating of pulsed current to a VCSEL. The circuit comprises a charge pump arrangement 1 for providing drive to a channel controller 2. The channel controller 2 may be repeated for each of a number of channels. The channel controller uses a replica load arrangement to set the current to be applied to the semiconductor laser 6. The semiconductor laser 6 is arranged between a high-side switch 8, which is part of the channel controller, and a low-side switch 7, which is part of a switch array 3. The switch array can include multiple low side switches for respective laser devices, as will be described below. A filter capacitor 9 is arranged between the high side of the laser diode 6 and ground.

In operation, the charge pump controls the current input to the channel controller. A feedback loop in the charge pump allows the operation of the charge pump to operate under closed loop control. The channel controller forms a signal at 10 which controls the high-side switch 8. Additionally, a channel select input 11 allows a higher level controller to select via switch 12 whether the illustrated channel, and correspondingly its laser, is to operate. Current flow through the high-side switch charges capacitor 9 in accordance with the desired lasing current requirement. When low-side switch 7 is opened the capacitor 9 discharges through the laser, causing it to emit light. Switch 7 can be controlled by gate pre-driver 13, e.g. to cause rapid pulsing of the laser's emission. In practice, there may be multiple such lasers, and one may be selected for operation by means of the channel select input 11, addressed to the appropriate channel controller, and the operation of the corresponding gate pre-driver.

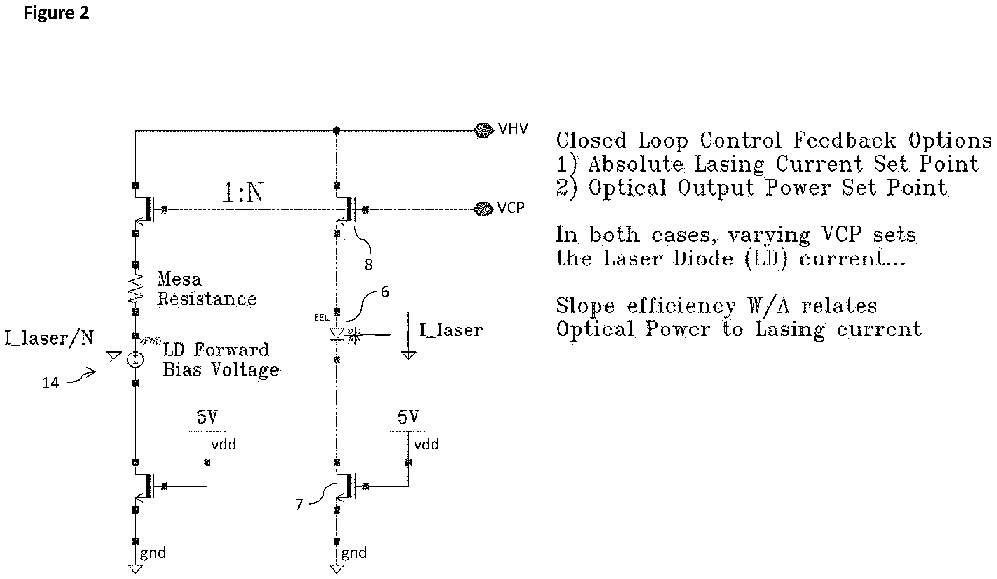

Figure 2 illustrates the mechanism for controlling laser current implemented by the charge pump 1. The circuit allows closed loop regulation of the lasing current to be done in dependence on a replica of the laser diode voltage/current (VI) characteristic. A replica circuit in the left limb of figure 2 comprises a load 14 which simulates the temperature response of the laser diode VI characteristic. The laser diode VI characteristic is approximated in the load as a voltage source plus a resistive element. Laser diodes can vary in their characteristics. A batch of laser diodes can be analysed and a representative mean or median can be used as the basis for design of the replica circuit. The tuning of the replica laser diode VI characteristic is performed by the selective programming of three settings: bias voltage at room temperature, bias voltage temperature coefficient and laser diode mesa resistance. These can be tuned using a band gap circuit, which may be provided on-chip. It can provide for a low temperature coefficient voltage reference (e.g. less than 50ppm), an inverse to absolute temperature current (ICTAT) and a proportional to absolute temperature current (IPTAT). Closed loop control can be used to apply an absolute lasing current set point or an optical output power set point.

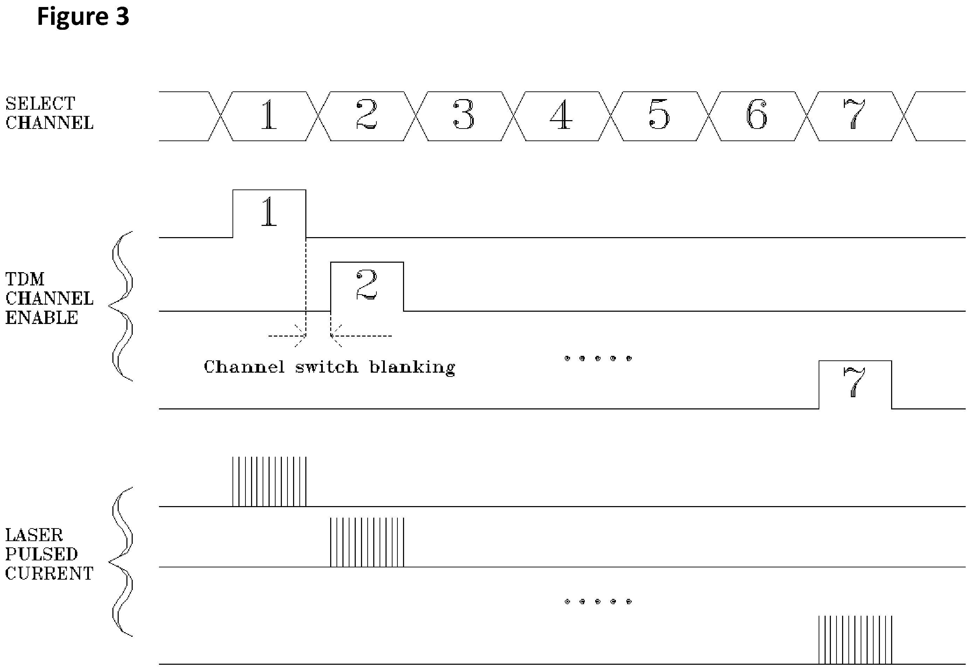

Figure 3 illustrates signalling timing in this system. There may be multiple channels, each corresponding to a respective semiconductor laser device. Seven channels are illustrated in figure 3. A channel enable signal 11 is asserted for each channel at the period when it is to be active. There may be a blanking period between assertions of successive enable signals. Then, when a channel is active the respective laser may be operated in a pulsed manner. Of note in this circuit is the unambiguous switching of channel selection with the insertion of a blanking period. Also the order of switching and switching frequency can be selectively controlled. The system can provide channel switching in sequential or non-sequential order: e.g. odd and even numbering interlaced order, randomized order or following an identifiable pre-programmable pseudo-random sequencing. Typically a receiver array (e.g. a CMOS array) is paired with the transmitter array. It is desirable for the receiver array to operate in the same order as the transmitter. The laser transmitter device may comprise a one-dimensional (1D) array. The 1D scanning frequency of such a transmitter may be synchronized to the scanning frequency of a receiver array. The scanning frequency of the receiver array may be provided by a rolling shutter. This synchronisation can help avoid temporal aliasing with the illumination light source (i.e. partial exposure of sensor).

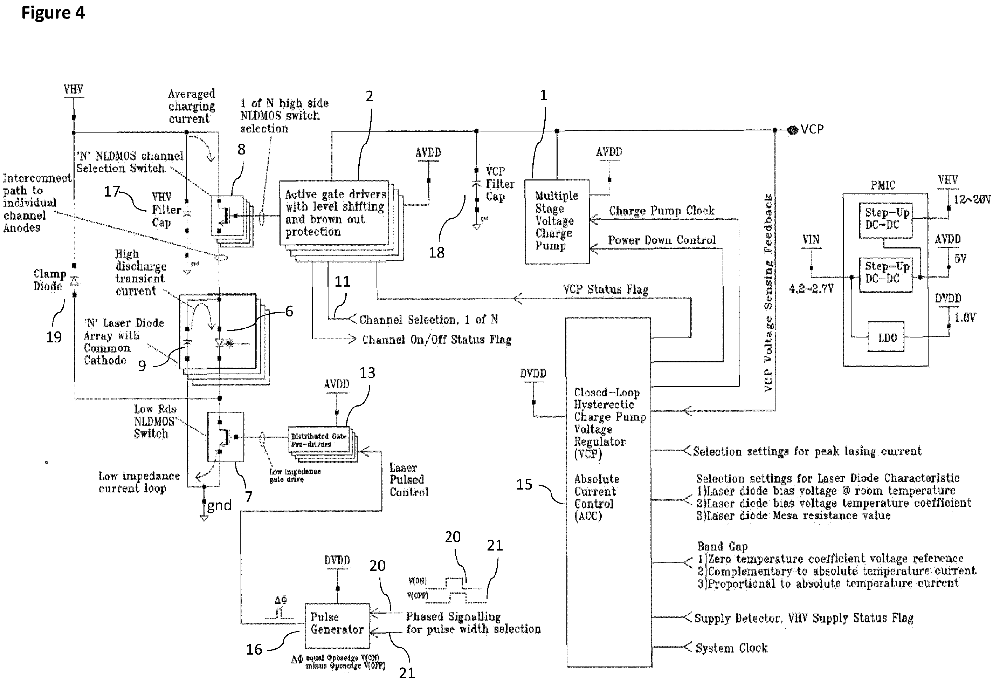

Figure 4 illustrates the high-side or channel selection switch 8 is conveniently an NMOS device, more preferably an N-channel Laterally-Diffused Metal-Oxide Semiconductor (NLDMOS) device. That can have the advantage of offering a layout sizing benefit, increasing the level of integration in a multiple channel laser diode array driver. The NLDMOS channel selection switch 8 is used to control the peak lasing current. Its gate source voltage is controlled with a charge pumped voltage. The sizing of the NLDMOS channel selection switch can be further reduced (i.e. requirements for its operating switching resistance relaxed) when each laser diode channel is paired with a high discharge low inductance capacitor 9. Another benefit of using an NLDMOS channel selection switch is that it provides an improved transient operation. The source follower configuration provides for a low impedance output. Also when in active operation a passive biasing current can be applied, avoiding channel inversion charge at turn on.

The low-side switch 7 may be an LDMOS switch. It may be used for modulating a pulsing regime of selectable pulse width and periodicity. This can prioritise the reduction of switching resistance and driving gate capacitance for high bandwidth pulsed current operation.

The closed loop regulation of the charge pump 1 is hysteretic. The gating of the charge pump clocks and thereby controls the power delivery by influencing the voltage/current product.

The replica laser diode circuit shown in figure 2 operates in ratiometric DC condition. The term ratiometric refers to tracking a scaled equivalent to actual applied peak pulsed lasing current. This mode of driving operation is referred to as Absolute Current Control (ACC). Because the electro-optical relationship of a laser diode has a dependence on its junction temperature, this approach can provide a means of mirroring the behaviour of a laser diode, with closed-loop feedback correction.

Figure 4 illustrates the system in more detail, and shows with stacked boxes where components can be replicated for each of multiple channels. Filter capacitors 17 and 18 can filter the voltage supplies VHV and VCP. A regulator 15 can perform closed-loop regulation of the charge pump 1. A clamp diode 19 can be provided between the voltage supply VHV which drives the laser and a node between the laser and the low-side switch 7. The gate driver(s) 13 can be controlled by a pulse generator 16. The pulse generator can generate short duration pulses for turning a selected laser on. Conveniently those short duration pulses can be generated from two pulse trains 20, 21, with each short duration pulse being initiated by a pulse edge in one of the pulse trains 20, 21 and terminated by a pulse edge in the other of the pulse trains 20, 21.

The high bandwidth requirements of a driving laser pulse of duration, e.g., less than 1ns can be relieved with the use of a pair of phased signals at pulsing frequency. These signals are gated so that an edge of one of the signals turns the laser diode on, and an edge of another of the signals turns the laser off. The bandwidth of these signals can be much lower than the bandwidth of the required pulse. The Bandwidth can be approximated as 0.35/rise time of signal, or otherwise, Fourier transform of a step function (i.e. a pulsed waveform) can be used to represent the spectral content in frequency domain. The phase difference in edges can be extracted. High frequency pulse generation can be distributed with respect to the large aspect ratio of the low side switch.

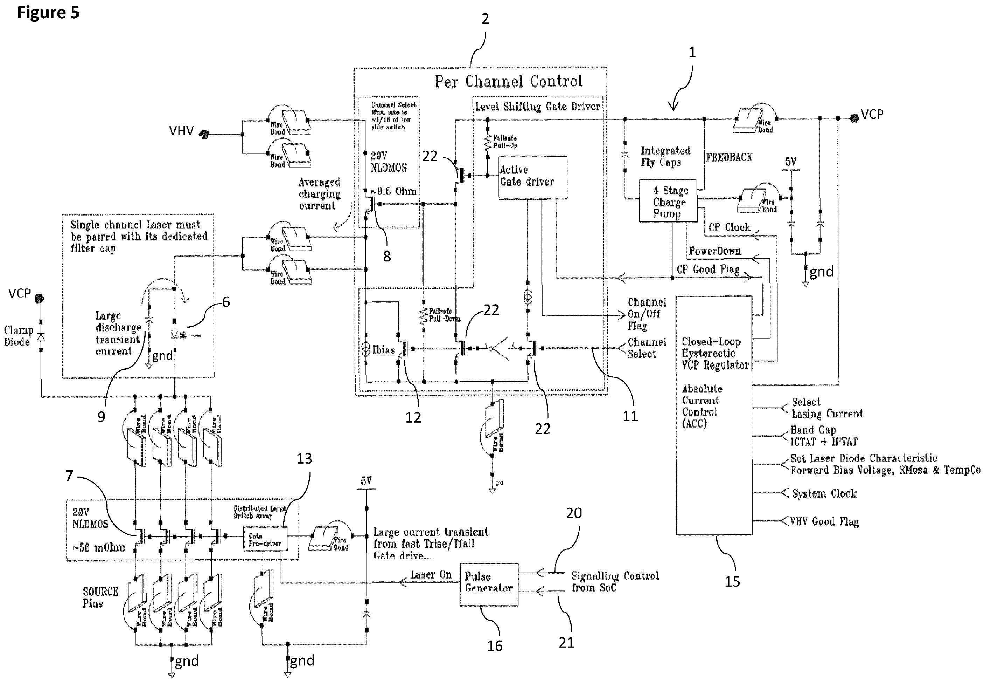

Figure 5 illustrates one example of how the system can be implemented using an integrated circuit.

The system can provide protection in the event of a brown out. That is a loss of full power, which may only be temporary. If any of the switches indicated by 12 and 22 in figure 5 were to fail open, the high-side switch 8 would be inoperative. Thus, the active gate driver has built-in passive pull-up and pull-down elements to terminate the lasing current path in the event of a brown-out condition. These elements can be overdriven in normal operation.

The system described herein can simplify the function of the low side laser diode switch in comparison to some prior art, because the present switch is only used for pulsed modulation. This can reduce switching losses (IR drop) and improve switching speed. The present system uses the high side switch for both the function peak current regulation, and also channel activation selection switch. In the present system the high side switch is an NLDMOS device. This can provide a benefit of layout implementation area reduction. These can be especially significant in generating high current (e.g. greater than 30Amps) sub-ns pulses.

Multiple high side NLDMOS devices may be provided. Such an array can allow for multiplex channel selection. Each channel pre-charges a respective discharging capacitor. This can offer good integration. The discharge capacitor can be a MLCC SMD or integrated on chip with other parts of the circuit.

By time division multiplexed switching of channels in a laser diode array, a field of view (FOV) can be sequentially constructed and its signal integrated by a receiver in tandem operation.

As noted above, both the pulse modulating switch 7 (which may be shared between multiple laser devices) and the channel selection switches 8 (of which there may be one per laser device) may be N-Type LDMOS devices. These can provide a smaller turn-on resistance (Rds) per device unit area in comparison to P-Type LDMOS devices. This can allow relatively high current switching requires with relatively low Rds for lower voltage drop. Also, the switching speed of the modulating switch can be intrinsically limited by a MOSFET gate capacitance (Cg), and can be in relationship to Rds (i.e. a lower Rds causes a higher Cg).

In pulsed current operation, there may be relatively high modulating current (>30 Amps) and relatively narrow pulse generation (<1ns). These can be impacted by the presence of parasitic inductance along the transient current path. To accommodate the voltage transient across these parasitic inductances (V = L.di/dt) the driver can be operated at a higher excess voltage compared to a DC biased condition.

In operation, to turn on the laser diode, the cathode of the laser diode is switched to ground. This can be done by a high speed pulse modulating switch 7, which may be common to multiple laser diodes. The or each channel selection switch 2 is connected to an anode of an individual laser diode and operates in isolation. Preferably no more than one channel is active at any time. The channel selection switch(es) 2 serve to gate the current path from a high side voltage rail to the or each laser diode anode. The frequency of channel switching may operates at a lower rate than the pulse modulating frequency.

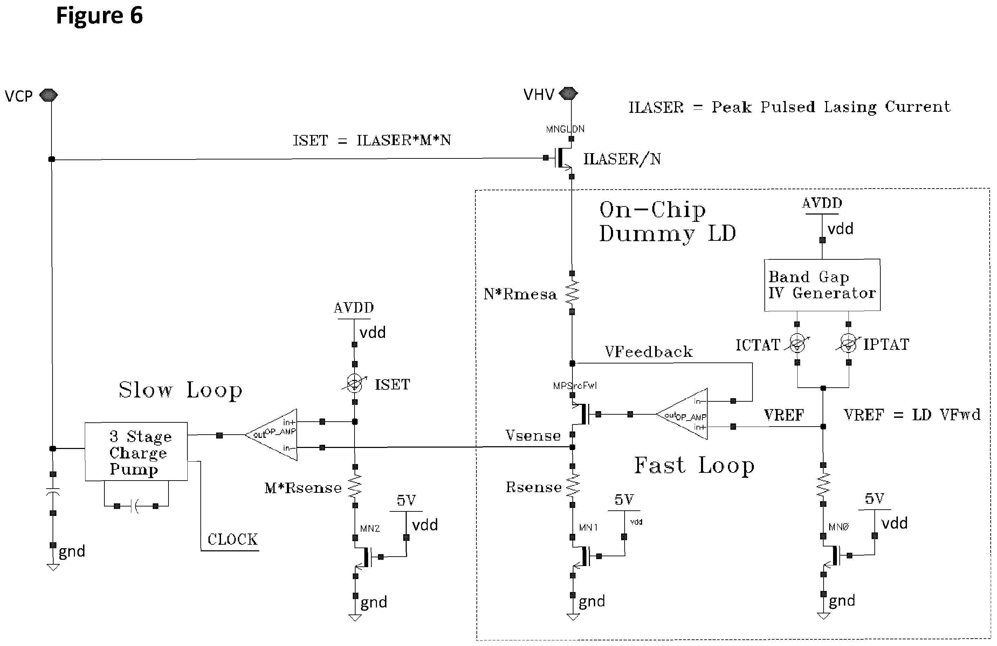

To facilitate the use of N-Type LDMOS (NLDMOS) channel selection switches, there may be a voltage higher than the anode bias voltage of the laser diode at peak lasing current (the source voltage) as a bootstrap voltage to turn on. Thus the gate-source voltage (Vgs) of the N-Type LDMOS may be above its threshold voltage. This can be achieved with the voltage regulated charge pump 1. The regulated output voltage of the charge pump effectively sets the peak lasing current by adjustment of the Vgs of the channel selection N-Type LDMOS switches. Closed loop feedback regulation of the charge pump can references a current sensing resistor, the effective voltage drop across this resistor representing the equivalent peak lasing current. Figure 6 shows how this can be implemented.

In practice, to compensate for the temperature characteristic of the laser diode, a piecewise approximation of the laser diode Current-Voltage (IV) characteristic can be extracted from measurement. A mirrored temperature coefficient can be re-created with an on chip band gap generator, forming a replica laser diode. The replica laser diode with an approximated IV characteristic is implemented within the closed-loop feedback, operating together with the voltage regulated charge pump, to control the peak laser current.

## Claims

1. A laser drive circuit comprising:
a high supply node configured for supplying a relatively high voltage;
a low supply node configured for supplying a relatively low voltage;
first and second laser drive outputs configured for connection across a laser (6) to provide a drive current to the laser;
a high-side switch (8) coupled between the high supply node and the first laser drive output, wherein the high-side switch is configured to be controlled to regulate the drive current supplied to the laser; and
a low-side switch (7) coupled between the low supply node and the second laser drive output, wherein the low-side switch is controlled to alternate its state between on and off states so as to pulse the operation of the laser;
a gate driver (2) configured for controlling the high-side switch; and
a charge pump (1) configured for regulating the supply of current to the gate driver under closed loop control by providing drive to a current driver (2);
the current driver (2) for supplying current to the high supply node, wherein the current driver is configured to temperature compensate the current supplied to the high supply node, and wherein the current driver comprises a replica circuit configured for simulating a temperature response of a circuit including a laser and the output of the current driver is dependent on the response of the replica circuit, wherein the replica circuit comprises a load (14) configured to simulate the temperature response of a laser diode characteristic.

2. A laser drive circuit as claimed in claim 1, wherein the high-side switch is an NMOS switch.

3. A laser drive circuit as claimed in any preceding claim, wherein the laser is coupled between the high side switch and the low side switch.

4. A laser drive circuit as claimed in any preceding claim, configured to be capable of selectively driving each of multiple first drive outputs to a laser array.

5. A laser drive circuit as claimed in claim 1, wherein the replica circuit has a current/voltage response that is substantially linear over an operating region which is temperature invariant.

6. A laser drive circuit as claimed in any preceding claim, comprising a switching circuit (3) configured for receiving first and second pulse trains having mutually offset phases, the switching circuit being configured to control the low-side switch to turn on in response to an edge of a first predetermined sense in the first pulse train and to turn off in response to an edge of a second predetermined sense in the second pulse train.

7. A laser drive circuit as claimed in any preceding claim, for driving multiple lasers (6), the circuit comprising, for each such laser:
a high supply node configured for supplying a relatively high voltage;
a low supply node configured for supplying a relatively low supply voltage;
first and second laser drive outputs configured for connection across a respective laser to provide a drive current to the laser;
a high-side switch (8) coupled between the respective high supply node and the respective first laser drive output, wherein the high-side switch is configured to be controlled to regulate the drive current supplied to the laser; and
a low-side switch (7) coupled between the respective low supply node and the respective second laser drive output, wherein the low-side switch is controlled to alternate its state between on and off states so as to pulse the operation of the laser.

8. A laser drive circuit as claimed in claim 7, comprising a channel selection circuit (2) configured for receiving a current supply and selectively directing that current supply to a respective one of the high-side switches.

9. A laser drive circuit as claimed in claim 8, wherein the channel selection circuit comprises a plurality of switches (8) operable to control drive to a respective laser, the switches being configured such that in the event of a failure of any such switch the current path to the respective laser will be interrupted.

10. A laser unit comprising:
a laser drive circuit as claimed in any preceding claim; and
a laser (6) coupled between the or each pair of first and second laser drive outputs.

11. An optical distance measuring unit comprising a laser unit as claimed in claim 10, the laser unit being arranged to intermittently irradiate a zone external to the laser unit by switching of respective high side switches (8), whereby the time of flight of signals from the or each laser (6) to a subject can be measured.

## Patentansprüche

1. Laserantriebsschaltung, umfassend:
einen hohen Versorgungsknoten, der zum Versorgen mit einer relativ hohen Spannung konfiguriert ist;
einen niedrigen Versorgungsknoten, der zum Versorgen mit einer relativ niedrigen Spannung konfiguriert ist;
einen ersten und einen zweiten Laserantriebsausgang, die zum Anschluss an einen Laser (6) konfiguriert sind, um dem Laser einen Antriebsstrom bereitzustellen;
einen High-Side-Schalter (8), der zwischen dem hohen Versorgungsknoten und dem ersten Laserantriebsausgang gekoppelt ist, wobei der High-Side-Schalter dazu konfiguriert ist, gesteuert zu werden, um den dem Laser zugeführten Antriebsstroms zu regulieren; und
einen Low-Side-Schalter (7), der zwischen dem niedrigen Versorgungsknoten und dem zweiten Laserantriebsausgang gekoppelt ist, wobei der Low-Side-Schalter gesteuert wird, um seinen Zustand zwischen einem Ein- und einem Aus-Zustand zu wechseln, um den Betrieb des Lasers zu pulsieren;
ein Gate-Treiber (2), der zum Steuern des High-Side-Schalters konfiguriert ist; und
eine Ladepumpe (1), die zum Regulieren der Stromversorgung zu dem Gate-Treiber unter Regelung durch Bereitstellen eines Antriebs für einen Stromtreiber (2) konfiguriert ist;
der Stromtreiber (2) zur Stromversorgung des hohen Versorgungsknotens, wobei der Stromtreiber dazu konfiguriert ist, den dem hohen Versorgungsknoten zugeführten Strom temperaturzukompensieren, und wobei der Stromtreiber eine Replikationsschaltung umfasst, die zum Simulieren einer Temperaturreaktion einer Schaltung konfiguriert ist, die einen Laser beinhaltet, und der Ausgang des Stromtreibers von der Reaktion der Replikationsschaltung abhängt, wobei die Replikationsschaltung eine Last (14) umfasst, die dazu konfiguriert ist, die Temperaturreaktion eines Laserdiodenmerkmals zu simulieren.

2. Laserantriebsschaltung nach Anspruch 1, wobei der High-Side-Schalter ein NMOS-Schalter ist.

3. Laserantriebsschaltung nach einem der vorhergehenden Ansprüche, wobei der Laser zwischen dem High-Side-Schalter und dem Low-Side-Schalter gekoppelt ist.

4. Laserantriebsschaltung nach einem der vorhergehenden Ansprüche, die dazu konfiguriert ist, zum selektiven Antreiben jedes von mehreren ersten Antriebsausgängen in ein Laserarray in der Lage zu sein.

5. Laserantriebsschaltung nach Anspruch 1, wobei die Replikationsschaltung eine Strom-/Spannungsreaktion aufweist, die über einen Betriebsbereich, welcher temperaturinvariant ist, im Wesentlichen linear ist.

6. Laserantriebsschaltung nach einem der vorhergehenden Ansprüche, umfassend einen Schaltkreis (3), der zum Empfangen einer ersten und einer zweiten Impulsfolge konfiguriert ist, die zueinander versetzte Phasen aufweisen, wobei der Schaltkreis dazu konfiguriert ist, den Low-Side-Schalter zu steuern, um sich als Reaktion auf eine Flanke einer ersten vorbestimmten Abtastung in der ersten Impulsfolge einzuschalten und als Reaktion auf eine Flanke einer zweiten vorbestimmten Abtastung in der zweiten Impulsfolge auszuschalten.

7. Laserantriebsschaltung nach einem der vorhergehenden Ansprüche zum Antreiben mehrerer Laser (6), wobei die Schaltung für jeden dieser Laser Folgendes umfasst:
einen hohen Versorgungsknoten, der zum Versorgen mit einer relativ hohen Spannung konfiguriert ist;
einen niedrigen Versorgungsknoten, der zum Versorgen mit einer relativ niedrigen Versorgungsspannung konfiguriert ist;
einen ersten und einen zweiten Laserantriebsausgang, die zum Anschluss an einen jeweiligen Laser konfiguriert sind, um dem Laser einen Antriebsstrom bereitzustellen;
einen High-Side-Schalter (8), der zwischen dem jeweiligen hohen Versorgungsknoten und dem jeweiligen ersten Laserantriebsausgang gekoppelt ist, wobei der High-Side-Schalter dazu konfiguriert ist, gesteuert zu werden, um den dem Laser zugeführten Antriebsstroms zu regulieren; und
einen Low-Side-Schalter (7), der zwischen den jeweiligen niedrigen Versorgungsknoten und den jeweiligen zweiten Laserantriebsausgang gekoppelt ist, wobei der Low-Side-Schalter gesteuert wird, um seinen Zustand zwischen einem Ein- und einem Aus-Zustand zu wechseln, um den Betrieb des Lasers zu pulsieren.

8. Laserantriebsschaltung nach Anspruch 7, umfassend eine Kanalauswahlschaltung (2), die zum Aufnehmen einer Stromversorgung und selektiven Leiten dieser Stromversorgung zu einem jeweiligen der High-Side-Schalter konfiguriert ist.

9. Laserantriebsschaltung nach Anspruch 8, wobei die Kanalauswahlschaltung eine Vielzahl von Schaltern (8) umfasst, die zum Steuern eines Antriebs zu einem jeweiligen Laser bedienbar ist, wobei die Schalter derart konfiguriert sind, dass in dem Falle eines Ausfalls eines solchen Schalters der Strompfad zu dem jeweiligen Laser unterbrochen wird.

10. Lasereinheit, umfassend:
eine Laserantriebsschaltung nach einem der vorhergehenden Ansprüche; und
einen Laser (6), der zwischen dem oder jedem Paar eines ersten und eines zweiten Laserantriebsausgangs gekoppelt ist.

11. Optische Distanzmesseinheit, umfassend eine Lasereinheit nach Anspruch 10, wobei die Lasereinheit angeordnet ist, um eine Zone außerhalb der Lasereinheit durch Umschalten jeweiliger High-Side-Schalter (8) intermittierend zu bestrahlen, wodurch die Laufzeit von Signalen aus dem oder jedem Laser (6) zu einem Subjekt gemessen werden kann.

## Revendications

1. Circuit de commande laser comprenant :
un nœud d'alimentation haute tension configuré pour fournir une tension relativement élevée ;
un nœud d'alimentation basse tension configuré pour fournir une tension relativement faible ;
des première et seconde sorties de commande laser configurées pour être connectées à un laser (6) afin de fournir un courant de commande au laser ;
un commutateur côté haut (8) couplé entre le nœud d'alimentation haute tension et la première sortie de commande laser, dans lequel le commutateur côté haut est configuré être commandé pour réguler le courant de commande fourni au laser ; et
un commutateur côté bas (7) couplé entre le nœud d'alimentation basse tension et la seconde sortie de commande laser, dans lequel le commutateur côté bas est commandé pour alterner son état entre les états marche et arrêt afin de faire pulser le fonctionnement du laser ;
un pilote de grille (2) configuré pour commander le commutateur côté haut ; et
une pompe de charge (1) configurée pour réguler l'alimentation en courant du pilote de grille sous contrôle en boucle fermée en fournissant un entraînement à un pilote de courant (2) ;
le pilote de courant (2) pour fournir du courant au nœud d'alimentation haute tension, dans lequel le pilote de courant est configuré pour compenser en température le courant fourni au nœud d'alimentation haute tension, et dans lequel le pilote de courant comprend un circuit réplique configuré pour simuler une réponse en température d'un circuit comportant un laser et la sortie du pilote de courant dépend de la réponse du circuit réplique, dans lequel le circuit réplique comprend une charge (14) configurée pour simuler la réponse en température d'une caractéristique de diode laser.

2. Circuit de commande laser selon la revendication 1, dans lequel le commutateur côté haut est un commutateur NMOS.

3. Circuit de commande laser selon une quelconque revendication précédente, dans lequel le laser est couplé entre le commutateur côté haut et le commutateur côté bas.

4. Circuit de commande laser selon une quelconque revendication précédente, configuré pour être capable de commander sélectivement chacune des multiples premières sorties de commande vers un réseau laser.

5. Circuit de commande laser selon la revendication 1, dans lequel le circuit réplique a une réponse courant/tension sensiblement linéaire sur une région de fonctionnement invariante en température.

6. Circuit de commande laser selon une quelconque revendication précédente, comprenant un circuit de commutation (3) configuré pour recevoir des premier et second trains d'impulsions ayant des phases mutuellement décalées, le circuit de commutation étant configuré pour commander le commutateur côté bas afin de s'activer en réponse à un front d'une première détection prédéterminée dans le premier train d'impulsions et de se désactiver en réponse à un front d'une seconde détection prédéterminée dans le second train d'impulsions.

7. Circuit de commande laser selon une quelconque revendication précédente, destiné à commander plusieurs lasers (6), le circuit comprenant, pour chaque laser :
un nœud d'alimentation haute tension configuré pour fournir une tension relativement élevée ;
un nœud d'alimentation basse tension configuré pour fournir une tension relativement faible ;
des première et seconde sorties de commande laser configurées pour être connectées à un laser respectif afin de fournir un courant de commande au laser ;
un commutateur côté haut (8) couplé entre le nœud d'alimentation haute tension respectif et la première sortie de commande laser respective,
dans lequel le commutateur côté haut est configuré pour être commandé pour réguler le courant d'alimentation fourni au laser ; et
un commutateur côté bas (7) couplé entre le nœud d'alimentation basse tension respectif et la seconde sortie de commande laser respective, dans lequel le commutateur côté bas est commandé pour alterner son état entre les états activé et désactivé afin de pulser le fonctionnement du laser.

8. Circuit de commande laser selon la revendication 7, comprenant un circuit de sélection de canal (2) configuré pour recevoir une alimentation en courant et diriger sélectivement cette alimentation en courant vers l'un des commutateurs côté haut.

9. Circuit de commande laser selon la revendication 8, dans lequel le circuit de sélection de canal comprend une pluralité de commutateurs (8) actionnables pour commander la commande d'un laser respectif, les commutateurs étant configurés de telle sorte qu'en cas de défaillance de l'un quelconque de ces commutateurs, le chemin de courant vers le laser respectif sera interrompu.

10. Unité laser comprenant :
un circuit de commande laser selon une quelconque revendication précédente ; et
un laser (6) couplé entre les ou chaque paire des première et seconde sorties de commande laser.

11. Unité de mesure de distance optique comprenant une unité laser selon la revendication 10, l'unité laser étant agencée pour irradier par intermittence une zone extérieure à l'unité laser en commutant les commutateurs latéraux haut respectifs (8), de sorte que le temps de vol des signaux de chaque laser (6) vers un sujet peut être mesuré.
